Europäisches Patentamt

European Patent Office

Office européen des brevets

(11) Numéro de publication : **0 573 359 A1**

# (12) DEMANDE DE BREVET EUROPEEN

(21) Numéro de dépôt : **93401414.3**

(22) Date de dépôt : **02.06.93**

(51) Int. Cl.$^5$ : **H03F 1/32, H03F 3/217**

(30) Priorité : **05.06.92 FR 9206836**

(43) Date de publication de la demande :
**08.12.93 Bulletin 93/49**

(84) Etats contractants désignés :
**CH DE FR GB LI SE**

(71) Demandeur : **THOMSON-CSF**
**51, Esplanade du Général de Gaulle**
**F-92800 Puteaux (FR)**

(72) Inventeur : **Boisriou, Philippe**
**THOMSON-CSF SCPI, BP 329**
**F-92402 Courbevoie Cedex (FR)**

(74) Mandataire : **Lincot, Georges et al**
**THOMSON-CSF, SCPI, B.P. 329, 50, rue**
**Jean-Pierre Timbaud**
**F-92402 Courbevoie Cédex (FR)**

(54) **Dispositif de traitement et de précorrection d'un signal audiofréquence avant son amplification dans une chaîne d'amplification d'un émetteur à modulation d'amplitude.**

(57) Le dispositif permet d'effectuer une précorrection des signaux audiofréquence avant leur amplification dans des chaînes d'amplification d'émetteurs à modulation d'amplitude comportant un nombre déterminé de modules générateurs d'impulsions modulées en largeur reliés en série à l'entrée d'un filtre.

Il comprend :

— un convertisseur analogique-numérique (8) du signal audiofréquence à transmettre en échantillons numériques

— un circuit d'interpolation (9) couplé en sortie du convertisseur analogique-numérique pour calculer respectivement par une interpolation linéaire la pente de variation et par une interpolation parabolique la valeur du signal audiofréquence appliquée à l'entrée du convertisseur analogique-numérique

et des moyens de mémorisation (10) couplés en sortie du circuit d'interpolation (9) pour mémoriser des valeurs de précorrection des échantillons de signal audiofréquence adressables par les valeurs d'interpolation du signal audiofréquence calculées par le circuit d'interpolation.

Application : Réalisation d'émetteurs radioélectriques.

FIG.3

EP 0 573 359 A1

La présente invention concerne un dispositif de traitement et de précorrection d'un signal audiofréquence avant son amplification dans une chaîne d'amplification d'un émetteur à modulation d'amplitude.

Elle s'applique notamment à la réalisation d'émetteurs à modulation d'amplitude comportant des chaînes de modulation à largeur d'impulsions.

Dans ces émetteurs le signal audiofréquence est converti en échantillons numériques pour être appliqué de la manière décrite par exemple dans la demande de brevet français n° 84 10806 (2 567 338), à une logique de commande de modules générateurs d'impulsions modulés en largeur, reliés en série à l'entrée d'un filtre. La logique de commande associe les modules en série en fonction de l'amplitude des échantillons numériques appliqués à la logique de commande afin de reconstituer le signal de modulation à la sortie du filtre. Cependant du fait que les modules générateurs d'impulsions sont formés par des dispositifs à semi-conducteurs hacheurs de courant, il apparaît une distorsion du signal audiofréquence à la sortie du filtre qui est due principalement à la fréquence de commutation des modules générateurs et cette distorsion produit des raies parasites dans le spectre audiofréquence transmis. Pour atténuer cette distorsion la fréquence de commutation des modules générateurs est choisie relativement grande par rapport à la fréquence du signal audiofréquence et les fréquences d'échantillonnage et de numérisation du signal audiofréquence sont déterminées de façon à être plus élevées que la fréquence de commutation des modules. Cependant ces dispositions s'avèrent insuffisantes et il existe toujours une distorsion assez importante surtout pour les forts taux de modulation.

Le but de l'invention est de pallier les inconvénients précités.

A cet effet, l'invention a pour objet un dispositif de traitement et de précorrection d'un signal audiofréquence avant son amplification dans une chaîne d'amplification d'un émetteur à modulation d'amplitude, la chaîne d'amplification comportant un nombre déterminé de modules générateurs d'impulsions modulées en largeur reliés en série à l'entrée d'un filtre caractérisé en ce qu'il comprend :

- un convertisseur analogique-numérique du signal audiofréquence à transmettre en échantillons numériques
- un circuit d'interpolation couplé en sortie du convertisseur analogique-numérique pour calculer respectivement par une interpolation linéaire la pente de variation et par une interpolation parabolique la valeur du signal audiofréquence appliquée à l'entrée du convertisseur analogique-numérique
- des moyens de mémorisation couplés en sortie du circuit d'interpolation pour mémoriser des valeurs de précorrection des échantillons de signal audiofréquence adressables par les valeurs d'interpolation du signal audiofréquence calculées par le circuit d'interpolation.

Le dispositif selon l'invention a pour avantage qu'il permet d'augmenter la fréquence apparente de numérisation du signal audiofréquence avec une précorrection qui permet d'améliorer le taux de distorsion audiofréquence en sortie de l'émetteur.

D'autres caractéristiques et avantages de l'invention apparaîtront ci-après à l'aide de la description qui suit faite en regard des dessins annexés qui représentent :

- les figures 1 et 2 deux modes de réalisation de chaînes d'amplification d'émetteur à modules générateurs d'impulsions,
- la figure 3 un mode de réalisation du dispositif de traitement et de précorrection d'un signal audiofréquence selon l'invention,
- la figure 4 un mode de réalisation du circuit d'interpolation de la figure 3;
- la figure 5 un mode de génération des valeurs de précorrection appliquées au dispositif de la figure 4.

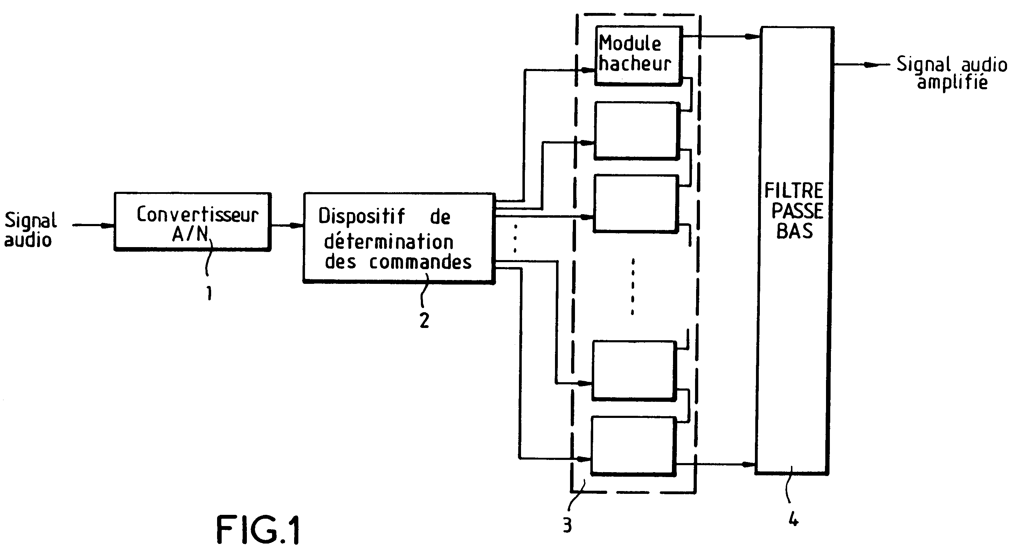

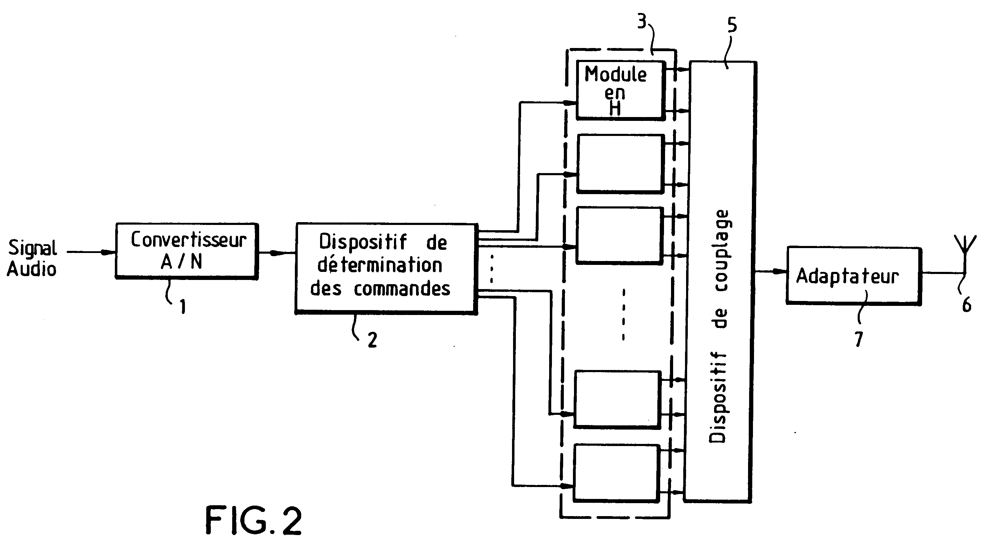

La chaîne d'émission à modules générateurs d'impulsion qui est représentée à la figure 1 comporte un convertisseur numérique-analogique 1 couplé par sa sortie à un dispositif de détermination de commandes 2 dont les sorties sont reliées à des modules générateurs d'impulsions 3 couplées en série avec un filtre passe-bas 4. Dans ce mode de réalisation le signal audiofréquence est appliqué sur l'entrée des convertisseurs analogiques-numériques 1. Les échantillons obtenus sont traités dans le dispositif de détermination de commandes 2 qui fournit une commande à chaque module générateur d'impulsions 3. Le signal en sortie des modules 3 est filtré de manière à reconstituer le signal audiofréquence par le filtre passe-bas 4, et l'appliquer à l'étage radiofréquence de l'émetteur non représenté. Sur la chaîne d'émission à étages d'amplification radiofréquence à semi-conducteurs qui est représentée à la figure 2 où les éléments homologues à ceux de la figure 1 sont représentés avec les mêmes références, les sorties des modules 3 sont couplées par un dispositif de couplage 5 à une antenne d'émission 6 par l'intermédiaire d'un adaptateur 7.

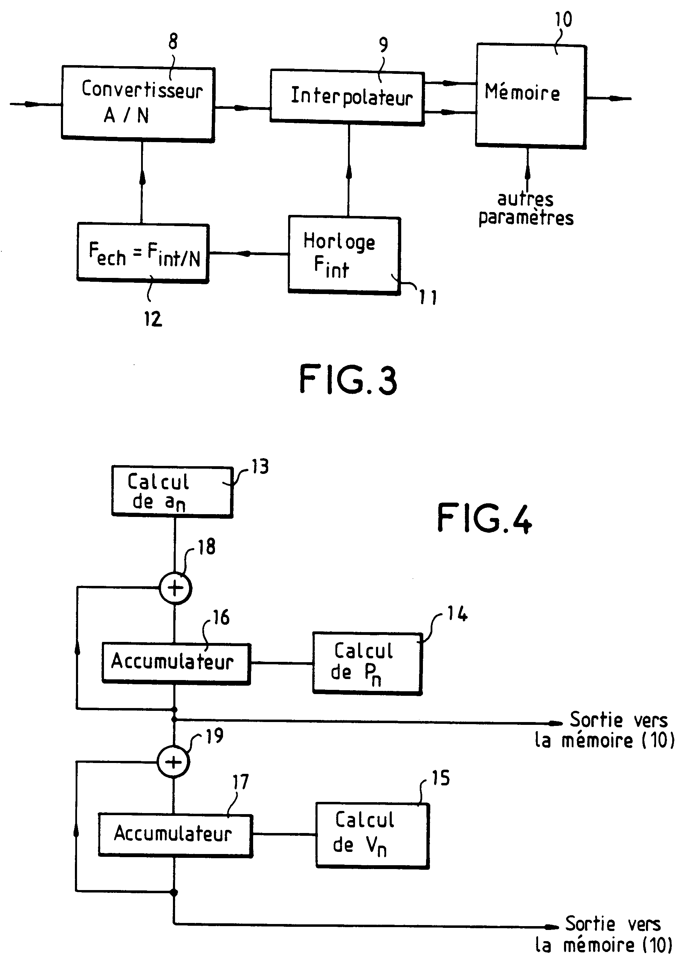

Suivant l'invention, le dispositif de traitement et de précorrection qui est représenté à la figure 3 se substitue au convertisseur analogique-numérique 1 pour appliquer au dispositif de détermination des commandes 2 des valeurs d'échantillons précorrigés. Ce dispositif comporte un convertisseur analogique-numérique 8 couplé à un dispositif d'interpolation 9 relié à des entrées d'adresse d'une mémoire de correction 10. Une horloge 11 applique des signaux de synchronisation au dispositif d'interpolation 9 et à un compteur 12 diviseur de fréquence pour fournir une fréquence d'échantillonnage pour le convertisseur analogique-numérique 8. Suivant ce dispositif le signal audiofréquence qui est appliqué à l'entrée du convertisseur analogique-numérique 8 est transformé en échantillons numériques à une fréquence qui peut être inférieure à la fréquence de commutation de l'étage à semi-conducteurs 3 des chaînes d'amplification représentées aux figures 1 et 2. En désignant par $U_n$ la suite des valeurs fournies par le convertisseur analogique-numérique 8 et par Fech la fréquence d'échantillonnage obtenue par division par un nombre déterminé N de la fréquence fournie par l'horloge 11 au dispositif d'interpolation 9 et au compteur 12, le dispositif interpolateur 9 calcule :

- des valeurs moyennes $V_n$ entre les échantillons courant et précédent suivant la relation
$$V_n = (U_{n-1} + U_n)/2$$
- une valeur de différence $P_n$ entre la valeur de l'échantillon courant $U_n$ et la valeur de l'échantillon précédent $U_{n-1}$
- ainsi qu'une valeur $a_n$ qui vérifie les relations
$$P_{n+1} = P_n + N.a_n$$
et
$$V_n = V_{n-1} + N.P_n + (N-1).N/2.a_n$$

Pendant chaque période d'échantillonnage Tech = 1/Fech le circuit d'interpolation 9 fournit N valeurs $P_n$ et $V_n$ telles que :
$$P_n(i) = P_n + i.a_n$$
$$V_n(i) = V_n + i.P_n + (i-1)i/2.a_n$$
pour i variant de 1 à N.

La suite des valeurs $P_n$ équivaut à une interpolation linéaire de la pente de variation du signal audiofréquence et la suite des valeurs $V_n$ correspond à une interpolation parabolique de la valeur du signal audiofréquence appliquée à l'entrée du convertisseur analogique-numérique 1.

A chaque période d'échantillonnage les valeurs $a_n$, $P_n$ et $V_n$ sont calculées respectivement par les organes de calcul 13, 14 et 15 représentés figure 4. La valeur $P_n$ obtenue est chargée dans un registre accumulateur 16 et la valeur $V_n$ est chargée dans un registre accumulateur 17. A chaque période du signal d'horloge fournie par l'horloge 11, la valeur $a_n$ est additionnée au contenu du registre accumulateur 16 et le contenu du registre accumulateur 17 est ajouté au contenu du registre accumulateur 16 par un additionneur 19.

Le contenu du registre accumulateur 16 correspond à la pente $P_n$ du signal audiofréquence et le contenu du registre accumulateur 17 correspond à la valeur $V_n$ du signal audiofréquence.

Les deux valeurs $P_n$ et $V_n$ servent à l'adressage de la mémoire 10 de la figure 3 qui contient soit des valeurs précorrigées du signal audiofréquence, soit un mot qui permet de produire une commande correspondant aux valeurs $P_n$ et $V_n$.

La mémoire 10 peut encore être adressée par d'autres paramètres tels que la fréquence du signal radiofréquence ou sa puissance moyenne dans la mesure où celles-ci peuvent servir à améliorer les performances en distorsion.

Les valeurs obtenues en sortie de la mémoire 10 sont transmises au dispositif de détermination des commandes à la fréquence Fint de l'horloge 11 qui peut être très élevée par rapport à la fréquence de commutation des modules afin de ne pas faire apparaître de raies gênantes dans le spectre du signal en sortie de l'émetteur.

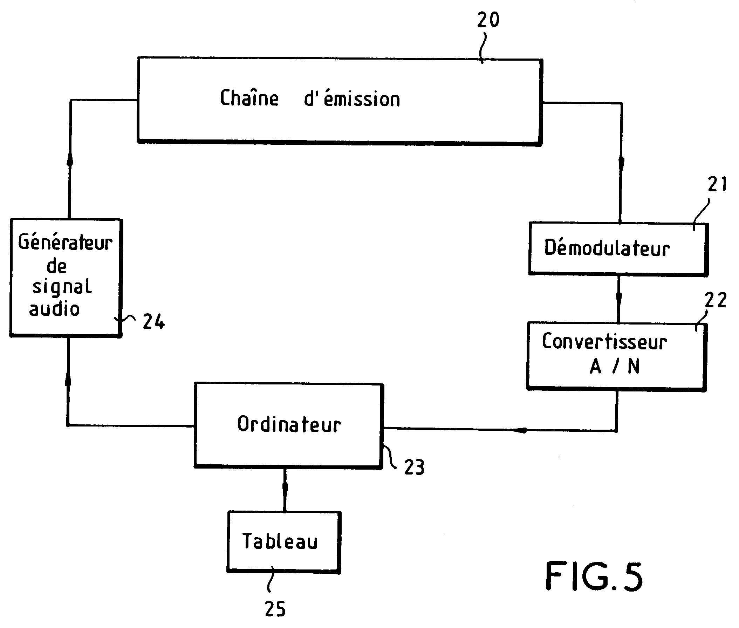

La mémoire 10 est réalisée au moyen de mémoires mortes programmables de grandes dimensions. Les valeurs précorrigées qui sont inscrites dans la mémoire 10 peuvent être obtenues à l'aide d'un banc de mesures d'un type équivalent à celui représenté à la figure 5. La chaîne d'émission qui est représentée dans le bloc 20 de la figure 5 est reliée sur sa sortie à un démodulateur 21 couplé à un convertisseur analogique-numérique 22. La sortie du convertisseur analogique-numérique 22 est reliée à un ordinateur 23 qui commande un générateur de signal audiofréquence 24 chargé de fournir un signal audiofréquence à l'entrée de la chaîne d'émission 20. L'analyse du signal qui est ainsi acquis en sortie de la chaîne d'émission par l'ordinateur 23 permet connaissant le signal qui a été délivré par le générateur de signal audiofréquence 24 de construire une table 25 de correction pouvant être mise en place par la suite dans la mémoire 10 de la figure 3.

## Revendications

1. Dispositif de traitement et de précorrection d'un signal audiofréquence avant son amplification dans une chaîne d'amplification d'un émetteur à modulation d'amplitude, la chaîne d'amplification comportant un nombre déterminé de modules générateurs d'impulsions (3) modulées en largeur reliés en série à l'entrée d'un filtre caractérisé en ce qu'il comprend :
   - un convertisseur analogique-numérique (8) du signal audiofréquence à transmettre en échantillons numériques
   - un circuit d'interpolation (9) couplé en sortie du convertisseur analogique-numérique pour calculer respectivement par une interpolation linéaire la pente de variation et par une interpolation parabolique la valeur du signal audiofréquence appliquée à l'entrée du convertisseur analogique-numérique
   - des moyens de mémorisation (10) couplés en sortie du circuit d'interpolation (9) pour mémoriser des valeurs de précorrection des échantillons de signal audiofréquence adressables par les valeurs d'interpolation du signal audiofréquence calculées par le circuit d'interpolation.

2. Dispositif selon la revendication 1 caractérisé en ce que le circuit d'interpolation (9) calcule d'une part une valeur moyenne $V_n$ d'amplitude entre la valeur de chaque échantillon courant et celle de l'échantillon qui le précède, une valeur de différence $P_n$ entre la valeur de chaque échantillon courant $U_n$ et la valeur de l'échantiUon qui le précède, et d'autre part, calcule pendant la durée de chaque période d'échantillonnage deux suites de N valeurs $P_n$ et $V_n$ d'interpolation linéaire et parabolique, correspondant respectivement l'une à une interpolation linéaire de la pente du signal audiofréquence et l'autre à une interpolation parabolique de la valeur du signal audiofréquence.

3. Dispositif selon la revendication 2, caractérisé en ce que le circuit d'interpolation (9) comprend un premier dispositif de calcul (14) de la valeur de différence $P_n$, un deuxième dispositif de calcul (15) de la valeur moyenne $V_n$, un troisième dispositif de calcul (13) d'une valeur d'incrément $a_n$ tel qu'entre trois échantillons successifs $U_{n-2}$, $U_{n-1}$ et $U_n$ les relations suivantes soient vérifiées :

$$P_{n+1} = P_n + N.a_n$$

et

$$V_n = V_{n-1} + NP_n + (N-1)N/2.a_n$$

dans lesquelles N est un nombre entier d'intervalles de temps partageant chaque période d'échantillonnage

- un premier registre accumulateur (16) pour cumuler dans chaque période d'échantillonnage la première suite des valeurs $P_n$ suivant la relation

$$P_n(i) = P_n + ia_n$$

dans laquelle i varie de 1 à N
- et un deuxième registre accumulateur (17) pour cumuler les valeurs $V_n$ durant chaque période d'échantillonnage suivant la relation

$$V_n = V_n + iP_n + (i-1).i/2.a_n$$

pour i variant également de 1 à N.

4. Dispositif selon la revendication 3 caractérisé en ce que les sorties des premier et deuxième circuits accumulateurs sont reliées aux entrées d'adressage des moyens de mémorisation (10).

5. Dispositif selon la revendication 4 caractérisé en ce que les valeurs de précorrection contenues dans les moyens de mémorisation (10) sont enregistrées à l'aide d'un banc de mesures formé par la chaîne d'émission (20) de l'émetteur couplée par ses entrée-sortie à un ordinateur (23) chargé d'effectuer l'analyse du signal acquis en sortie de la chaîne d'émission pour le comparer au signal correspondant qui a été appliqué à l'entrée de la chaîne d'émission et construire une table (25) de valeurs de correction correspondante enregistrée dans les moyens de mémorisation (10).

Signal audio amplifié

FILTRE PASSE BAS

4

Module hacheur

3

Dispositif de détermination des commandes

2

Convertisseur A/N

1

Signal audio

FIG.1

FIG.2

EP 0 573 359 A1

Convertisseur
A / N — 8

Interpolateur — 9

Mémoire — 10

autres
paramètres

$F_{ech} = F_{int}/N$ — 12

Horloge
$F_{int}$ — 11

## FIG.3

Calcul
de $a_n$ — 13

## FIG.4

18 (+)

Accumulateur — 16

Calcul
de $P_n$ — 14

Sortie vers
la mémoire (10)

19 (+)

Accumulateur — 17

Calcul
de $V_n$ — 15

Sortie vers
la mémoire (10)

Chaîne d'émission — 20

Démodulateur — 21

Convertisseur A / N — 22

Ordinateur — 23

Générateur de signal audio — 24

Tableau — 25

FIG.5

EP 0 573 359 A1

**Office européen des brevets** — **RAPPORT DE RECHERCHE EUROPEENNE** — Numero de la demande

EP 93 40 1414

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | AUDIO ENGINEERING SOCIETY AN AUDIO ENGINEERING SOCIETY PREPRINT PRESENTED AT THE 76TH CONVENTION 8 Octobre 1984, NEW YORK pages 1 - 14 M. SANDLER 'TOWARDS A DIGITAL POWER AMPLIFIER' * page 2; figures 1-5 * * page 8, alinéa 3 - page 9 * | 1,2 | H03F1/32 H03F3/217 |
| A | EP-A-0 421 532 (LABORATOIRES D'ELCTRONIQUE PHILIPS) 10 Avril 1991 * le document en entier * | 1-5 | |
| A | E. KREYSZY 'ADVANCED ENGINEERING MATHEMATICS' 1979 , JOHN WILEY & SONS INC. , NEW YORK USA * page 774, alinéa 19.4 - page 775, ligne 6; figure 350 * | 1-3 | |

DOMAINES TECHNIQUES RECHERCHES (Int. Cl.5)

H03F
H03H

Le présent rapport a été établi pour toutes les revendications

| Lieu de la recherche | Date d'achèvement de la recherche | Examinateur |
|---|---|---|
| LA HAYE | 14 SEPTEMBRE 1993 | TYBERGHIEN G.M. |